# EUROPEAN PATENT APPLICATION

(11) **EP 4 632 802 A1**
(43) Date of publication of application: **15.10.2025**
(21) Application number: 25165621.1
(22) Date of filing: 24.03.2025
(51) Int. Cl.: H01L 21/768, H01L 21/321

(54) **SEMICONDUCTOR DEVICE INCLUDING INTERCONNECT STRUCTURE WITH CAPPING STRUCTURE**

(30) Priority: 29.03.2024 US 202463571816 P; 24.07.2024 US 202418782713
(71) Applicant: Samsung Electronics Co., Ltd., Suwon-si, Gyeonggi-do 16677 (KR)
(72) Inventor: OH, Joongsuk, San Jose, CA 95134 (US); CHOI, Jaemyung, San Jose, CA 95134 (US); KIM, Johnsoo, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Provided is a semiconductor device which includes: a base layer; a 1^{st} metal line on the base layer; a 1^{st} capping structure on the 1^{st} metal line; and an isolation structure surrounding the 1^{st} metal line and the 1^{st} capping structure, wherein the isolation structure and the 1^{st} capping structure comprise different dielectric materials.

## Description

### BACKGROUND

### 1. Field

Apparatuses and methods consistent with example embodiments of the disclosure relate to a semiconductor device including an interconnect structure in which a capping structure is formed on a metal line.

### 2. Description of the Related Art

Performance of a semiconductor device is affected by how an interconnect structure is formed in the semiconductor device. The interconnect structure includes back-end-of-line (BEOL) structures such as metal lines and vias which connect front-end-of-line (FEOL) structures to a voltage source or other circuit elements through middle-of-line (MOL) structures. The FEOL structures include transistor structures such as a channel structure, source/drain regions, and a gate structure, and the MOL structures include contact plugs formed on the source/drain regions and the gate structures.

As semiconductor devices are developed to have a high device density and performance, design and formation of an interconnect structure including metal lines and vias become more difficult and complicated while improved resistance and capacitance (RC) characteristics are required for the semiconductor device.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

The disclosure provides example embodiments of an interconnect structure of a semiconductor device in which a capping structure is formed on a metal line, wherein the capping structure remains on the metal line after an inter-metal dielectric (IMD) structure is formed based on the capping structure that prevents a via loss at a top via formed on a neighboring metal line and IMD dishing.

According to one or more embodiments, there is provided a semiconductor device which may include: a base layer; a 1^{st} metal line on the base layer; a 1^{st} capping structure on the 1^{st} metal line; and an isolation structure surrounding the 1^{st} metal line and the 1^{st} capping structure, wherein the isolation structure and the 1^{st} capping structure comprise different dielectric materials.

According to one or more embodiments, the semiconductor device may further include: a 2^{nd} metal line at a same level as the 1^{st} metal line; and a top via formed on the 2^{nd} metal line, wherein the top via is a protrusion structure of the 2^{nd} metal line.

According to one or more embodiments, there is provided a semiconductor device which may include: a 1^{st} metal line: a 1^{st} capping structure on the 1^{st} metal line, the 1^{st} capping structure comprising a dielectric material; and a 1^{st} top via on a portion of the 1^{st} metal line wherein the 1^{st} capping structure is not formed, wherein the 1^{st} top via is a protrusion structure of the 1^{st} metal line, and wherein the 1^{st} top via and the 1^{st} capping structure are at a same level and have a same height.

According to one or more embodiments, the semiconductor device may further include: a 2^{nd} metal line at a same level as the 1^{st} metal line; and a 2^{nd} top via on the 2^{nd} metal line, wherein the 2^{nd} top via is a protrusion structure of the 2^{nd} metal line, and wherein the 1^{st} capping structure is at a side of the 2^{nd} top via in a direction in which the 1^{st} metal line and the 2^{nd} metal line are arranged.

According to one or more embodiments, there is provided a method of manufacturing a semiconductor device. The method may include: forming a base layer; forming a 1^{st} metal line on the base layer; patterning the 1^{st} metal line by a predetermined thickness; forming a capping structure on the 1^{st} metal line; and forming an isolation structure surrounding the 1^{st} metal line with the capping structure thereon, wherein the capping structure and the isolation structure comprise different dielectric materials.

According to one or more embodiments, the method may further include: forming a 2^{nd} metal line at a same level as the 1^{st} metal; and masking a portion of the 2^{nd} metal line and patterning the 2^{nd} metal line by the predetermined thickness based on the masking to form a top via on the 2^{nd} metal line, wherein the forming the isolation structure is performed such that the isolation structure surrounds the 2^{nd} metal line with the top via thereon.

### BRIEF DESCRIPTION OF DRAWINGS

Example embodiments of the disclosure will be more clearly understood from the following detailed description taken in conjunction with the accompanying drawings as follows.
FIGS. 1A-1C illustrate a semiconductor device including an interconnect structure, according to one or more embodiments.
FIG. 2 illustrates a semiconductor device including an interconnect structure in which a via loss has occurred to a top via.
FIG. 3 illustrates a semiconductor device including an interconnect structure in which IMD dishing has occurred.
FIGS. 4A-4C illustrate a semiconductor device including an interconnect structure in which capping structures are formed on portions of metal lines where top vias are not formed, according to one or more embodiments.
FIGS. 5A-5N illustrate cross-section views of an intermediate semiconductor device including an interconnect structure after respective steps of manufacturing a semiconductor device including an interconnect structure in which capping structures are formed on portions of metal lines where top vias are not formed, according to one or more embodiments.
FIG. 6A illustrates an intermediate semiconductor device alternative to the intermediate semiconductor device shown in FIG. 5M, and FIG. 6B illustrates an intermediate semiconductor device alternative to the intermediate semiconductor device shown in FIG. 5N, according to one or more embodiments.
FIGS. 7A and 7B illustrate a flowchart for a method of manufacturing a semiconductor device including an interconnect structure in which capping structures are formed on portions of metal lines where top vias are not formed, in reference to FIGS. 5A-5N, according to one or more other embodiments.
FIG. 8 is a block diagram of a system-on-chip (SoC) 1000 including a semiconductor device in which the interconnect structure shown in FIGS. 4A-4C is formed, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements of a semiconductor device may or may not be described in detail herein or shown in the drawings. For example, MOL or FEOL structures may not be shown or described in detail when these structures are not relevant to the concept of the disclosure.

Herebelow, various embodiments of the disclosure are described in reference to the accompanying drawings.

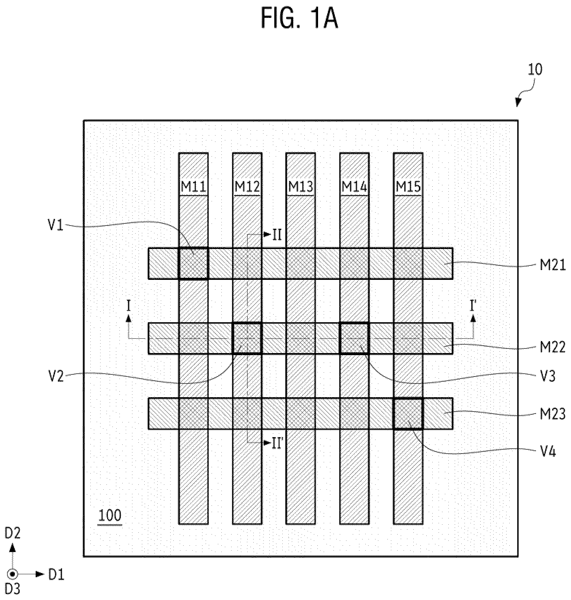

FIGS. 1A-1C illustrate a semiconductor device including an interconnect structure, according to one or more embodiments.

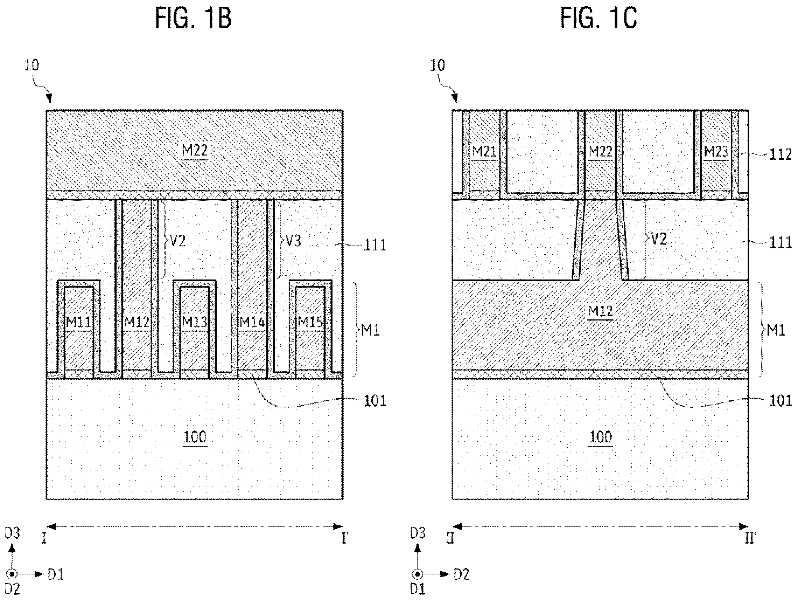

FIG. 1A is a plan view of the semiconductor device, FIG. 1B is a side cross-sectional view of the semiconductor device taken along a line I-I' shown in FIG. 1A, and FIG. 1C is a side cross-section view of the semiconductor device taken along a line II-II' shown in FIG. 1A.

Referring to FIGS. 1A-1C, an interconnect structure 10 formed in a BEOL process may be disposed on a base layer 100. Here, the base layer 100 may be a BEOL layer including another interconnect structure, a middle-of-line (MOL) layer, or a front-end-of-line (FEOL) layer forming a transistor structure of a semiconductor device.

The interconnect structure 10 may include a plurality of M1 metal lines M11-M15 at an M1 level (or M1 metal layer), a plurality of top vias V1-V4 on the M1 metal lines M11, M12, M14 and M15, and a plurality of M2 metal lines M21-M23 at an M2 level (or M2 metal layer) above the M1 level in a D3 direction. The M1 metal lines, the top vias, and the M2 metal lines may be surrounded by inter-metal dielectric (IMD) structures 111 and 112, respectively, which are electrical isolation or insulation structures. The M1 metal lines may be arranged in a D1 direction at a predetermined pitch and extended in a D2 direction, and the M2 metal lines formed above the M1 metal lines with the top vias V1-V4 therebetween may be arranged in the D2 direction at a predetermined pitch and extended in the D1 direction. The M1 metal lines M11-M15 may each have a same width in the D1 direction, and the M2 metal lines M21-M23 may each have a same width in the D2 direction, which may be the same as or different from that of the M1 metal lines.

The D1 direction and the D2 directions are each a horizontal direction and intersect each other. The D3 direction is a vertical direction intersecting the D1 direction and the D2 direction.

The top via V1 may connect the M1 metal line M11 with the M2 metal line M21, the top via V2 may connect the M1 metal line M12 with the M2 metal line M22, the top via V3 may connect the M1 metal line M14 with the M2 metal line M22, and the top via V4 may connect the M1 metal line M15 with the M2 metal line M23.

It is noted here that the M1 metal lines may be formed in the lowest layer of the BEOL layer. However, the disclosure is not limited thereto, and there may be one or more other metal lines and vias below the M1 metal lines to form an extended interconnect structure of the semiconductor device. Further, the number of the metal lines and top vias is not limited to those shown in FIG. 1A to form the interconnect structure 10.

The interconnect structure 10 may be formed through a top via process, in which the top vias V1-V4 are formed from underlying metal lines, respectively. For example, the top via V1 may be formed from the M1 metal line M11, the top vias V2 may be formed from the M1 metal line M12, the top via V3 may be formed from the M1 metal line M14, and the top via V4 may be formed from the M1 metal line M15. Thus, each of the top vias V1-V4 may be a part of the corresponding underlying M1 metal line itself, and each of the top vias V1-V4 and the corresponding underlying M1 metal line may be a single continuum structure that does not have a boundary, a connection surface or an interface therebetween, unlike a damascene metal line and a damascene via thereon that are formed through respective damascene processes. Each of these top vias V1-V4 may take a form of a pillar-type protrusion on the underlying metal line.

The via structure like each of the top vias V1-V4 is introduced to reduce contact resistance and capacitance existing between a metal line and a via formed thereon through a conventional damascene process, which adversely affects at least connection performance of a semiconductor device including the metal line and the via. At least for the foregoing purpose, and to facilitate the top via process, a metal such as ruthenium (Ru) may be patterned to form the M1 metal lines M11-M15 with the top vias V1-V4 thereon. Alternatively, molybdenum (Mo) or cobalt (Co) may be patterned to form the M1 metal lines M11-M15 with the top vias V1-V4 thereon, not being limited thereto.

At a bottom surface of each of the M1 metal lines may be formed a bottom liner 101 which reduces contact resistance and provides adhesion properties between each of the M1 metal lines and an underlying structure in the base layer 100. The bottom liner 101 may be formed of a material such as titanium nitride (TiN), tantalum nitride (TaN), etc., not being limited thereto.

At a side surface of each of the M1 and M2 metal lines and the top vias may be formed a sidewall liner 102 which prevents or reduces electromigration of metal atoms (e.g., Ru) into the IMD structure 111 which is formed of a low-k material such as silicon oxide (SiO₂, etc.), not being limited thereto, to isolates the M1 metal lines and the top vias from each other and isolate the M2 metal lines from each other. The sidewall liner 102 may also provide adhesion properties between the IMD structure 111 and the M1 and M2 metal lines and the top vias. The sidewall liner 102 may be formed of a material such as a composite of silicon nitride (e.g., SiCN, SiBCN, etc.), not being limited thereto. It is to be appreciated here that the sidewall liner 102 is not shown in FIG. 1A for brevity purposes.

When the M1 and M2 metal lines and the top vias are formed of ruthenium (Ru), which provides a lower resistance and a reduced electromigration property than other metal materials such as copper (Cu), the sidewall liner 102 may not be formed at the side surfaces of these metal structures. However, to more effectively prevent or reduce the electromigration of metal atoms, the sidewall liner 102 may be formed even at the side surfaces of the metal structures of the interconnect structure 10 when the metal structures are formed of ruthenium (Ru).

In the meantime, in the interconnect structure 10, the M1 metal lines with the top vias thereon may be formed such that: (i) the M1 metal lines are first patterned out from an initial metal structure (e.g., Ru) through, for example, direct etching thereon; (ii) portions of the M1 metal lines where the top vias are to be formed are masked, and the M1 metal lines are recessed based on the masking to form the top vias on the M1 metal lines, respectively; (iii) the sidewall liner 102 may be formed to surround the M1 metal lines with the top vias thereon; (iv) the IMD structure 111 is formed to surround the M1 metal lines with the top vias thereon; and (v) the IMD structure 111 is planarized though, for example, chemical-mechanical polishing (CMP) to expose top surfaces of the top vias though the IMD structure 111 for connection with overlying M2 metal lines.

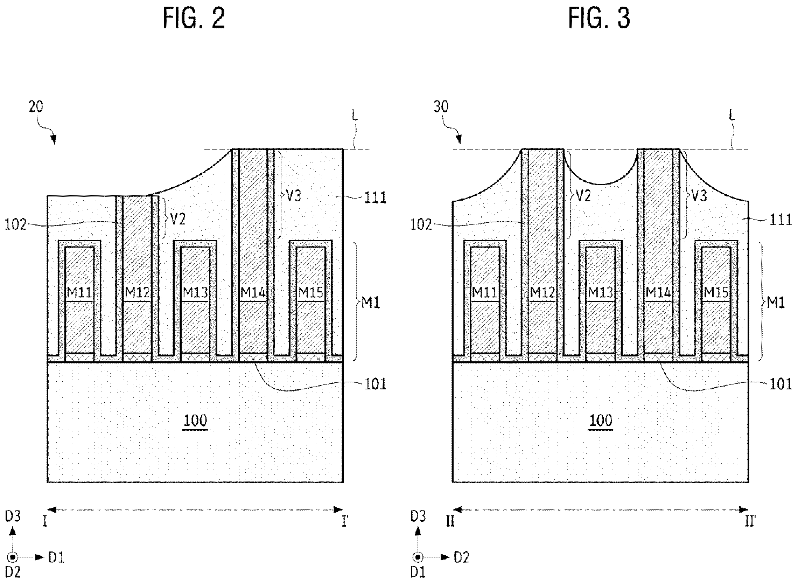

However, as a global density of the top vias is generally very low in the interconnect structure 10, that is, the number of the top vias V1-V4 is very small, e.g., 1-3%, compared to the entire area of the interconnect structure 10, as shown in FIG. 1A, stopping the IMD planarization operation (v) immediately after the top surfaces of the top vias are detected or exposed is very difficult. Thus, over-polishing (e.g., over-CMP) may occur to at least one of the top vias on the M1 metal lines, resulting in a via loss to the at least one of the top vias. For example, as shown in FIG. 2, the via loss may occur to a top via V2 on an M1 metal line M12 while no via loss may occur to a top via V4 in an interconnect structure 20 which corresponds to the interconnect structure 10 of FIG. 1B. In this example, a portion of the M1 metal line M12 is recessed together with an IMD structure 111 around the M1 metal line M12, below a level L where an M2 metal line is to be formed, because of the over-polishing. When the via loss randomly occurs in this manner, a subsequent operation of forming an overlying M2 metal line to contact the top vias may become incomplete and unreliable because of the different heights of the top vias.

In another example, top vias may be early detected in an IMD planarization operation (v) to timely stop this operation and expose the top surfaces of the top vias, thereby preventing the via loss. However, in this example as shown in FIG. 3, an IMD dishing may occur to an IMD structure 111 of an interconnect structure 30 corresponding to the interconnect structure 10 of FIG. 1B because of difference in rigidity and etch selectivity between a low-k dielectric material (e.g., SiO₂) forming the IMD structure 111 and a metal material (e.g., Ru) forming top vias V2 and V3. When the IMD dishing occurs, the IMD structure 111 may be over-etched outwardly from the top vias V2 and V3. As a result of the IMD dishing, a short-circuit risk may increase between the M1 metal lines below the over-etched portion of the IMD structure 111 and an overlying M2 metal line or any other circuit elements that are to be formed above the over-etched IMD structure 111.

Embodiments presented herebelow address the above-described via loss and IMD dishing in the interconnect structure 10 of the semiconductor device.

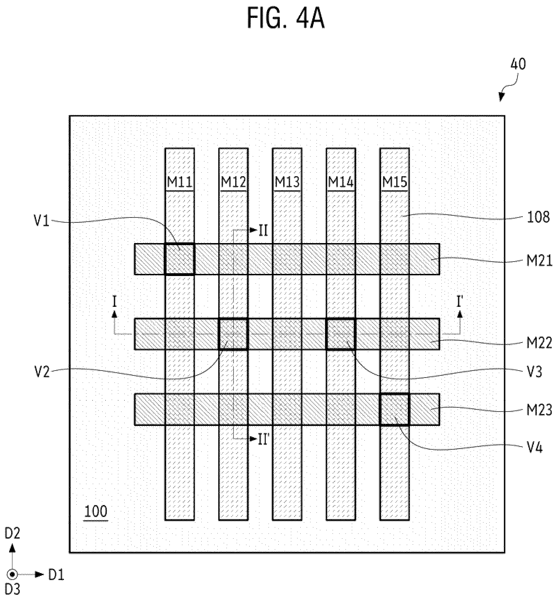

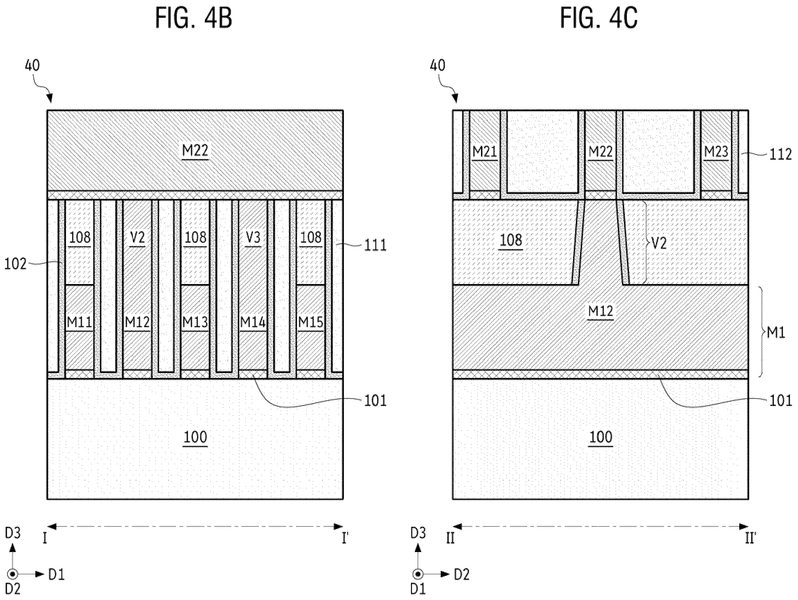

FIGS. 4A-4C illustrate a semiconductor device including an interconnect structure in which capping structures are formed on portions of metal lines where top vias are not formed, according to one or more embodiments. FIG. 4A is a plan view of the semiconductor device, FIG. 4B is a side cross-sectional view of the semiconductor device taken along a line I-I' shown in FIG. 4A, and FIG. 4C is a side cross-section view of the semiconductor device taken along a line II-II' shown in FIG. 4A.

Referring to FIGS. 4A-4C, an interconnect structure 40 may have the same metal structure arrangement as in the interconnect structure 10 of FIGS. 1A-1C. Thus, duplicate descriptions thereof may be omitted herein, and instead, different aspects of the interconnect structure 40 may be described herebelow using the same reference numerals and characters in the FIGS. 1A-1C.

Unlike the interconnect structure 10, the interconnect structure 40 may include capping structures 108 on portions of M1 metal lines M11-M15 where top vias V1-V4 are not formed. A material forming the capping structures 108 may differ from a material forming IMD structures 111 and 112; for example, the capping structure material may include silicon nitride (e.g., SiN, Si₃N₄, etc.) or a composite thereof (e.g., SiBCN, SiCN, etc.), not being limited thereto, and the IMD structure material may include silicon oxide (e.g., SiO₂).

The capping structures 108 may be formed such that top surfaces of the capping structures 108 are horizontally coplanar or aligned with top surfaces of the top vias V1-V4 in the D1 direction and the D2 direction. Thus, the top surfaces of the capping structures 108 may also be connected to or contact M2 metal lines M21-M23, respectively. Further, the capping structures 108 and the top vias V1-V4 may have a same height in the D3 direction, and the capping structures 108, the M1 metal lines M11-M15, and the top vias V1-V4 may have a same width in the D1 direction.

For example, as shown in FIGS. 4A and 4B, the capping structures 108 on the M1 metal lines M11, M13 and M15 may be horizontally coplanar or aligned with the top surfaces of the top vias V2 and V3, and may be connected to or contact the M2 metal line M22. Further, as shown in FIGS. 4A and 4C, the capping structure 108 may be formed on a portion of the M1 metal line M12 where the top via V2 is not formed. This capping structure 108 may also be horizontally coplanar or aligned with the top via V2 on the M1 metal line M12, and may be extended to contact the M2 metal lines M21 and M23.

A sidewall liner 102 formed on side surfaces of the M1 metal lines and the top vias thereon may also be formed on side surfaces of the capping structures 108. For example, as shown in FIG. 4B, the sidewall liner 102 formed on the side surfaces of the M1 metal lines M11, M13 and M15 may be extended to be formed on the side surfaces of the capping structures 108 formed thereon.

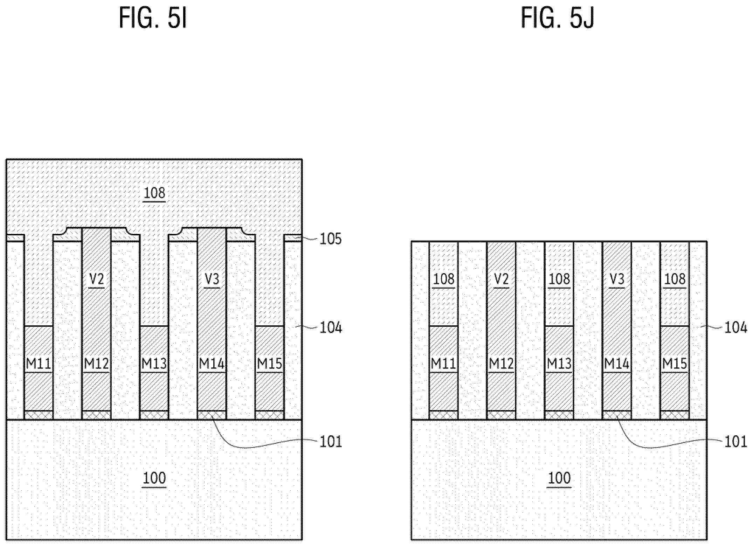

As will be described later in reference to FIG. 5I, the capping structures 108 may be formed on the M1 metal lines before the IMD structure 111 is formed to surround the M1 metal lines, and thus, the via loss and the dishing phenomenon that may occur during the IMD planarization operation as shown FIGS. 2 and 3 may be avoided.

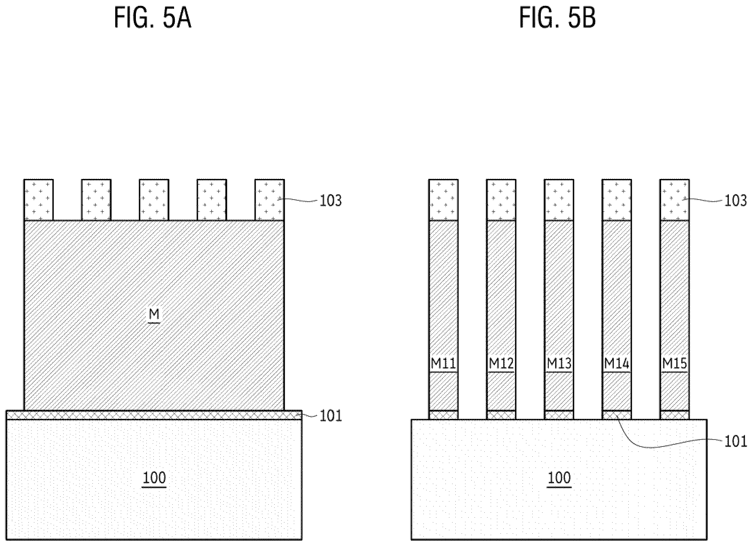

Herebelow, a method of manufacturing a semiconductor device including the interconnect structure 40 may be described in reference to FIGS. 5A-5N.

FIGS. 5A-5N illustrate cross-section views of an intermediate semiconductor device including an interconnect structure after respective steps of manufacturing a semiconductor device including an interconnect structure in which capping structures are formed on portions of metal lines where top vias are not formed, according to one or more embodiments.

The semiconductor device manufactured in reference to FIGS. 5A-5N may be or correspond to the semiconductor device including the interconnect structure 40 shown in FIGS. 4A-4C, and the cross-section view of each of the intermediate semiconductor devices shown in FIGS. 5A-5N corresponds to that shown in FIG. 4B. Thus, duplicate descriptions about the same structural elements described above in reference to FIGS. 4A-4C may be omitted, and the same reference numerals and characters shown in FIGS. 4A-4B may be used in the description herebelow.

Referring to FIG. 5A, an initial metal structure M may be formed on a base layer 100 with a bottom liner 101 therebetween, followed by forming a plurality of 1^{st} hard mask patterns 103 on a top surface of the initial metal structure M at positions below which a plurality of preliminary M1 metal lines are to be patterned out in a next step. The 1^{st} hard mask patterns 103 may be arranged at a predetermined pitch in the D1 direction, which is to be a pitch of the preliminary M1 metal lines to be formed therebelow.

The material forming the initial metal structure M may be ruthenium (Ru) which provides a lower resistance and a reduced electromigration property than other metal materials such as copper (Cu). Molybdenum (Mo) or cobalt (Co) may be alternatively form the initial metal structure M.

As described earlier, the base layer 100 may be another BEOL layer, an MOL layer, or an FEOL layer forming a transistor structure of a semiconductor device. The bottom liner 101 may be formed of a material such as titanium nitride (TiN), tantalum nitride (TaN), etc., not being limited thereto. The 1^{st} hard mask patterns 103 to pattern the initial metal structure M formed of Ru may be formed of a material such as silicon nitride (SiN), TiN or TaN, not being limited thereto.

Referring to FIG. 5B, a plurality of preliminary M1 metal lines M1-M15 may be patterned out from the initial metal structure M based on the hard mask patterns 103.

Direct etching on the initial metal structure M may be performed through, for example, dry etching such as reactive ion etching (RIE) to form the preliminary M1 metal lines M11-M15 having a predetermined pitch based on the 1^{st} hard mask patterns 103. When the initial metal structure M is patterned, the bottom liner 101 may also be patterned to form a plurality of bottom liners 101 below the preliminary M1 metal lines M11-M15.

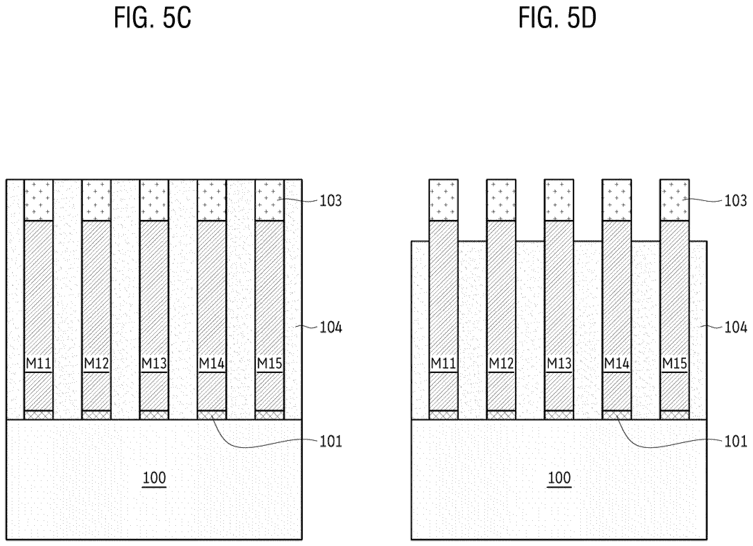

Referring to FIG. 5C, an initial IMD structure 104 may be formed on the intermediate semiconductor device obtained in the previous step (FIG. 5B) to surround the preliminary M1 metal lines M11-M15 with the 1^{st} hard mask patterns 103 thereon.

The formation of the initial IMD structure 104 may be performed by depositing an oxide material such as silicon oxide (e.g., SiO₂) on the intermediate semiconductor device including the preliminary M1 metal lines M11-M15 with the respective 1^{st} hard mask patterns 103 thereon through, for example, physical vapor deposition (PVD), chemical vapor deposition (CVD), plasma enhanced chemical vapor deposition (PECVD), atomic layer deposition (ALD), etc., not being limited thereto. The deposition of the oxide material may be followed by planarization on top thereof such that top surfaces of the initial IMD structure 104 and the 1^{st} hard mask patterns 103 are horizontally coplanar or aligned in the D1 direction and the D2 direction.

Referring to FIG. 5D, the initial IMD structure 104 may be recessed down to a predetermined level below a level of top surfaces of the preliminary M1 metal lines M11-M15 so that portions of the preliminary M1 metal lines M11-M15 above the predetermined level and the hard mask patterns 103 thereon are exposed above the recessed initial IMD structure 104 in a protrusion form.

The predetermined level to which the initial IMD structure 104 is recessed in this step may be a level of top surfaces of a plurality of top vias and capping structures to be formed in a later step (FIG. 5J). The recess of the initial IMD structure 104 may be performed through, for example, dry etching, not being limited thereto.

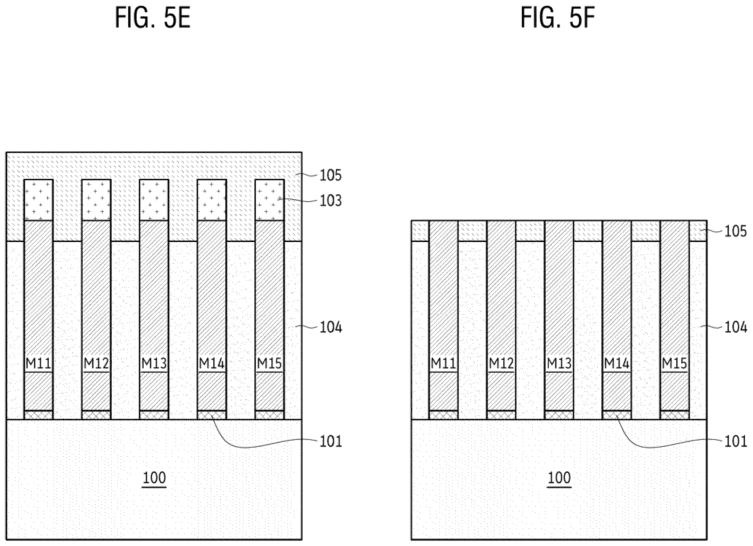

Referring to FIG. 5E, a 1^{st} protection layer 105 may be formed on the intermediate semiconductor device obtained in the previous step (FIG. 5D) to cap the initial IMD structure 104.

The 1^{st} protection layer 105 may be formed by depositing a nitride material such as silicon nitride (e.g., SiN, Si₃N₄, etc.) or a composite thereof (e.g., SiBCN, SiCN, etc.) on the intermediate semiconductor device of FIG. 5D including the preliminary M1 metal lines M11-M15 with the respective 1^{st} hard mask patterns 103 thereon and the initial IMD structure 104 through, for example, PVD, CVD, PECVD, ALD, etc., not being limited thereto.

The 1^{st} protection layer 105 may be formed on the recessed initial IMD structure 104 to enclose portions of the preliminary M1 metal lines M11-M15 above a level of the top surface of the initial IMD structure 104 and the 1^{st} hard mask patterns 103 thereabove, thereby to protect the initial IMD structure 115 in subsequent operations.

Referring to FIG. 5F, a planarization operation may be performed on the 1^{st} protection layer 105 and the 1^{st} hard mask patterns 103 enclosed by the 1^{st} protection layer 105 to remove the 1^{st} hard mask patterns 103 and expose the top surfaces of the preliminary M1 metal lines M11-M15.

The planarization operation in this step may be performed through, for example, CMP such that top surfaces of the planarized 1^{st} protection layer 105 and the top surfaces of the preliminary M1 metal lines M11-M15 are horizontally coplanar or aligned in the D1 direction and the D2 direction. At this time, side surfaces of the portions of the preliminary M1 metal lines M11-M15 above the level of the top surface of the initial IMD structure 104 may be surrounded by the planarized 1^{st} protection layer 105.

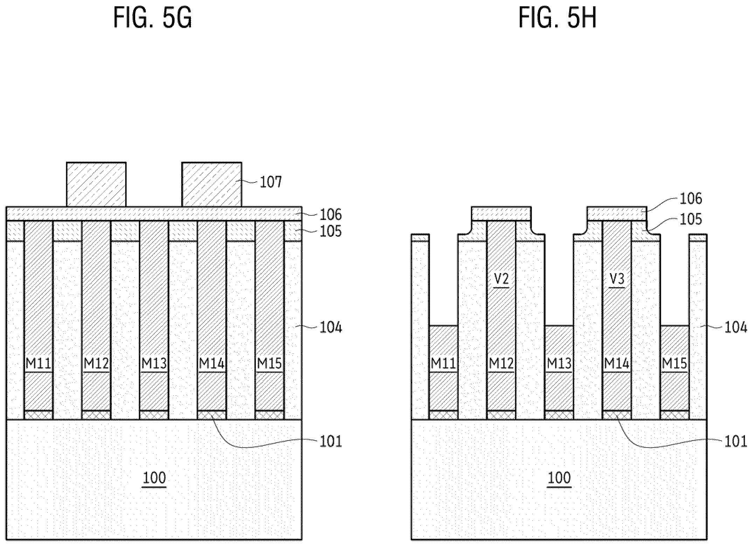

Referring to FIG. 5G, a 2^{nd} protection layer 106 may be formed on the top surfaces of the preliminary M1 metal lines M11-M15 and the planarized 1^{st} protection layer 105, and a plurality of 2^{nd} hard mask patterns 107 may be formed on a top surface of the 2^{nd} protection layer 106 at positions below which top vias are to be formed in a next step (FIG. 5H).

The 2^{nd} protection layer 106 may be formed to protect the preliminary M1 metal lines M11-M15, of which the top surfaces are exposed in the previous step (FIG. 5F), from subsequent operations including forming the 2^{nd} hard mask patterns 107 and patterning the preliminary M1 metal lines M11-M15 except ones to form preliminary top vias thereon in the next step (FIG. 5H).

The 2^{nd} protection layer 106 may be formed by depositing a nitride material such as silicon nitride (e.g., SiN, Si₃N₄, etc.) or a composite thereof (e.g., SiBCN, SiCN, etc.) on the top surfaces of the preliminary M1 metal lines M11-M15 and the planarized 1^{st} protection layer 105 through, for example, PVD, CVD, PECVD, ALD, etc., not being limited thereto, followed by planarization on top thereof. The 2^{nd} protection layer 106 may be formed of a material different from that forming the 1^{st} protection layer 105.

The 2^{nd} hard mask patterns 107 may be formed of a material such as silicon oxide (SiO₂), not being limited thereto, having etch selectivity against the silicon nitride, a composite thereof, and metal (e.g., Ru) forming the preliminary M1 metal lines M11-M15. The 2^{nd} hard mask patterns 107 may be formed on the top surface of the 2^{nd} protection layer 106 at positions above the preliminary M1 metal lines M12 and M14 from which preliminary top vias are to be patterned out in a next step (FIG. 5H). A width of each of the 2^{nd} hard mask patterns 107 may be greater than or equal to a width of each of the preliminary M1 metal lines M12 and M14 so that the preliminary M1 metal lines M12 and M14 can be sufficiently masked to pattern the preliminary top vias thereon based on the 2^{nd} hard mask patterns 107.

Referring to FIG. 5H, portions of the 2^{nd} protection layer 106 and the 1^{st} protection layer 105 not masked by the 2^{nd} hard mask patterns 107 and an upper portion of each of the preliminary M1 metal lines M11-M15 therebelow are patterned to form a plurality of M1 metal lines M11-M15 and a plurality of preliminary top vias including the preliminary top vias V2 and V3 respectively on the M1 metal lines M12 and M14. These preliminary top vias may be formed on portions of the M1 metal lines M12 and M14 which are masked by the 2^{nd} hard mask patterns 107, and thus, not patterned in this step.

The patterning operation used in this step may be dry etching or wet etching, not being limited thereto, that selectively etches silicon nitride, its composite, and the metal (e.g., Ru) against silicon oxide (e.g., SiO₂) of the initial IMD structure 104.

Here, the patterning operation may be performed until a desired height of each of the M1 metal lines M11-M15 is obtained. While the metal forming the preliminary M1 metal lines M11-M15 and the material forming the 2^{nd} protection layer 106 are patterned, a minimal amount of the 1^{st} protection layer 105 formed on the initial IMD structure 104 may remain without entirely being removed as shown in FIG. 5H due to the material difference between the 1^{st} protection layer 105 and the 2^{nd} protection layer 106.

Referring to FIG. 5I, an initial capping structure 108 may be formed on the intermediate semiconductor device obtained in the previous step (FIG. 5H) to fill out spaces formed by removing the upper portions of the M1 metal lines M11-M15.

The initial capping structure 108 may be formed by depositing a nitride material such as silicon nitride (e.g., SiN, Si₃N₄, etc.) or a composite thereof (e.g., SiBCN, SiCN, etc.), not being limited thereto, which may be the same as the material forming the 2^{nd} protection layer 106, in spaces formed by removing the upper portions of the M1 metal lines M11-M15, where the preliminary top vias are not formed, through, for example, PVD, CVD, PECVD, ALD, etc., not being limited thereto.

Referring to FIG. 5J, the intermediate semiconductor device obtained in the previous step may be planarized until top surfaces of the initial IMD structure 104 and the top vias including the top vias V2 and V3 are detected and exposed.

For the planarization operation in this step, CMP, for example, may be applied to the initial capping structure 108, the 2^{nd} protection layer 106 formed below the removed 2^{nd} hard mask patterns 107 and the remaining 1^{st} protection layer 105 which are all formed of a nitride-based material until the top surfaces of the initial IMD structure 104 formed of an oxide material (e.g., SiO₂) are detected and exposed. At this time when the nitride-based material is planarized, portions of the preliminary top vias V1-V4, that is, portions of the preliminary M1 metal lines M11, M12, M14 and M15, where the initial capping structure 108 is not formed, laterally surrounded by the 1^{st} protection layer 105 may also be removed to form a plurality of top vias V1-V4.

The nitride planarization operation in this step may stop when the top surfaces of the oxide-based initial IMD structure 104 are detected and exposed. Thus, after the nitride planarization operation stops in this step, the top surfaces of the initial IMD structure 104, the top vias V1-V4, and the capping structures 108 formed in the spaces formed by removing the upper portions of the M1 metal lines M11-M15 in the previous step (FIG. 5H) may be horizontally coplanar or aligned in the D1 direction and the D2 direction.

The M1 metal lines M11-M15 and the top vias V1-V4 obtained in this step may be used as a final form of the M1 metal lines and the top vias of an interconnect structure for a semiconductor device because, unlike copper (Cu), ruthenium (Ru) having a reduced electromigration property forms the M1 metal lines and the top vias. However, to more effectively prevent or reduce the electromigration of metal atoms, a sidewall liner may be formed in subsequent steps herebelow.

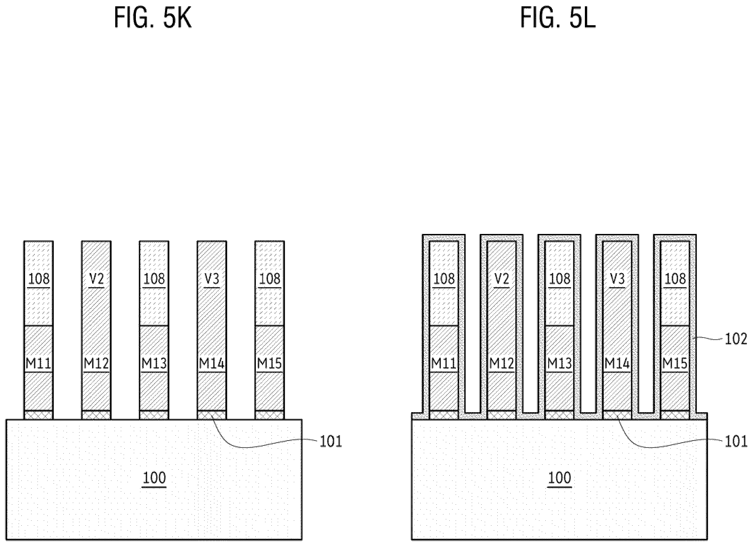

Referring to FIG. 5K, the initial IMD structure 104 formed between the M1 metal lines and between the top vias and the M1 metal lines.

The removal of the initial IMD structure 104 may be performed through, for example, masking the top vias V1-V4 and the M1 metal lines M11-M15 and extracting the initial IMD structure 104 through, for example, dry etching or wet etching, not being limited thereto.

Referring to FIG 5L, a sidewall liner 102 may be conformally formed on the top surfaces and side surfaces of the M1 metal lines M11-M15 and the top vias V1-V4.

The formation of the sidewall liner 102 may be performed through, for example, atomic layer deposition (ALD) of a silicon nitride composite (e.g., SiCN, SiBCN, etc.), not being limited thereto, on the top surfaces and side surfaces of the M1 metal lines M11-M15 and the top vias V1-V4 obtained by removing the initial IMD structure 104 in the previous step (FIG. 5K).

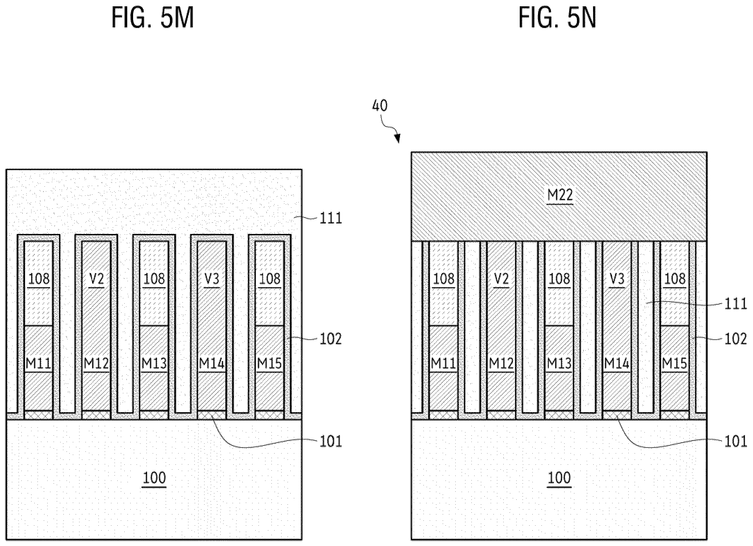

Referring to FIG. 5M, an IMD structure 111 may be formed on the intermediate semiconductor device obtained in the previous step (FIG. 5L) to surround the top vias V1-V4, the M1 metal lines M11-M15, and the capping structures 108 on portions of the M1 metal lines where the top vias are not formed.

The formation of the IMD structure 111 may be performed through, for example, depositing a low-k material such as silicon oxide (e.g., SiO₂, etc.) through, for example, PVD, CVD, PECVD, ALD, etc., not being limited thereto, to isolate the M1 metal lines M11-M15 and the top vias V1-V4 from each other.

Referring to FIG. 5N, the IMD structure 111 may be planarized to expose the top surfaces of the top vias V1-V4, the capping structures 108 formed on portions of the M1 metal lines M11-M15 where the top vias V1-V4 are not formed, and the planarized IMD structure 111, followed by formation of M2 metal lines M21-M23 contacting the capping structures 108 as well as the top vias V1-V4.

In the IMD planarization in this step, the sidewall liner 102 on the top surfaces of the capping structures 108 and the top vias V1-V4 may also be removed.

Here, due to the capping structures 108, the IMD planarization step may stop at a level of the horizontally coplanar or aligned top surfaces of the top vias V1-V4 and the capping structures 108, thereby preventing the via loss or the IMD dishing that may occur in planarizing the IMD structure 111 to form the interconnect structure 10 as shown in FIGS. 1A-1C.

After the planarization of the IMD structure 111, the M2 metal lines M21-M23 may be formed on the top surfaces of the top vias V1-V4, the capping structures 108 and the planarized IMD structure 111 with another bottom liner 101 therebetween, thereby completing the interconnect structure 40 of FIGS. 4A-4C.

In the meantime, when the low-k material is deposited to form the IMD structure 111 as shown in FIG. 5M, the low-k material may not be entirely filled in a narrow space between each of the M1 metal lines with the corresponding top via thereon and a neighboring M1 metal line with a corresponding capping structure 108 thereon, and thus, an air gap may be formed in the IMD structure 111 in this narrow space.

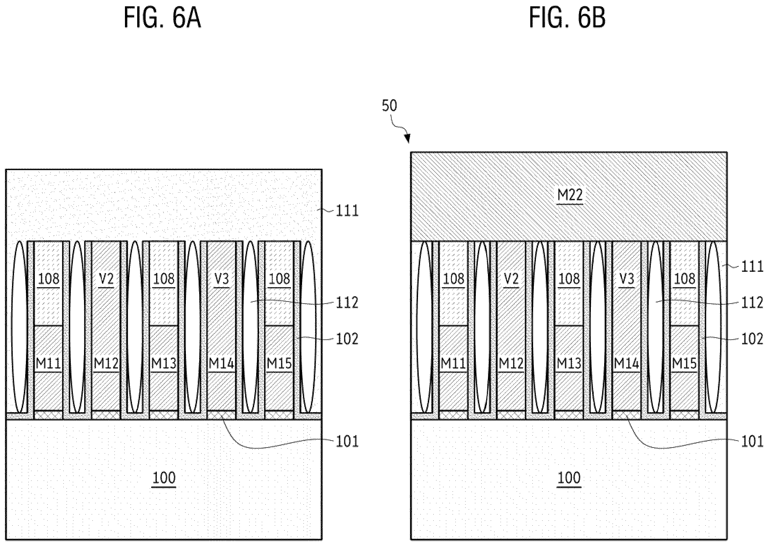

For example, FIG. 6A illustrates an intermediate semiconductor device alternative to the intermediate semiconductor device shown in FIG. 5M. Referring to FIG. 6A, an air gap may be formed between the M1 metal line M13 with the capping structure 108 thereon and the M1 metal line M14 with the top via V3 thereon to isolate the M1 metal line M13 and the M1 metal line M14 with the top via V3 thereon. Subsequently, an M2 metal line M21-M23 may be formed on top surfaces of the capping structures 108, the top vias V1-V4, and the planarized IMD structure 111 with a bottom liner 101 therebetween to complete an interconnect structure 50, as shown in FIG. 6B.

With the air gap formed in the IMD structure 111 as shown in FIGS. 6A and 6B, isolation or insulation properties between neighboring M1 metal lines and neighboring top vias may increase to further enhance interconnect performance of a semiconductor device including the interconnect structure 50.

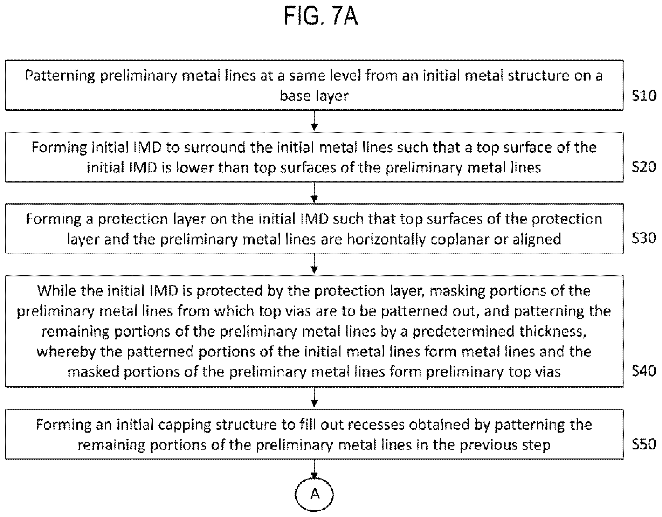

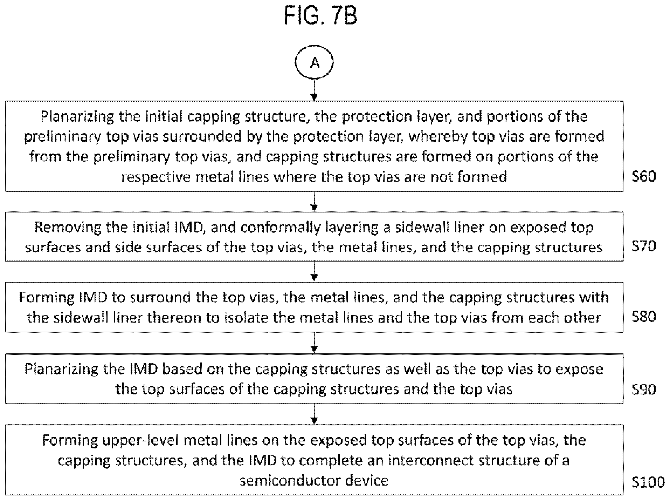

FIGS. 7A and 7B illustrate a flowchart for a method of manufacturing a semiconductor device including an interconnect structure in which capping structures are formed on portions of metal lines where top vias are not formed, in reference to FIGS. 5A-5N, according to one or more other embodiments.

In step S 10, a plurality of preliminary metal lines at a same level may be patterned out from an initial metal structure on a base layer (FIGS. 5A and 5B).

The initial metal structure may include a material such as ruthenium (Ru), and the preliminary metal lines may be a BEOL interconnect structure formed above a transistor structure. The preliminary metal lines may be arranged at a predetermined pitch and have a same width in the direction of the metal line arrangement.

In step S20, an initial IMD structure may be formed to surround the initial metal lines such that a top surface of the initial IMD structure is lower than top surfaces of the preliminary metal lines (FIGS. 5C and 5D). The initial IMD structure may be formed of an oxide material such as silicon oxide (SiO₂).

In step S30, a protection layer may be formed on the initial IMD structure such that a top surface of the protection layer is horizontally coplanar or aligned with the top surfaces of the preliminary metal lines (FIGS. 5E and 5F). The protection layer may be formed of a nitride material such as silicon nitride (e.g., SiN, Si₃N₄, etc.) or a composite thereof (e.g., SiBCN, SiCN, etc.).

In step S40, while the initial IMD structure is protected by the protection layer, portions of the preliminary metal lines from which top vias are to be patterned out may be masked, and the remaining portions of the preliminary metal lines may be patterned (removed) by a predetermined thickness, whereby the patterned portions of the initial metal lines form a plurality of metal lines and the masked portions of the preliminary metal lines form a plurality of preliminary top vias (FIGS. 5G and 5H). Here, the protection lay may refer to the 1^{st} protection layer 105 shown in FIGS. 5E.

In step S50, an initial capping structure may be formed to fill out recesses obtained by patterning the remaining portions of the preliminary metal lines in the previous step (S40). The initial capping structure may be formed of a material such as silicon nitride (e.g., SiN, Si₃N₄, etc.) or a composite thereof (e.g., SiBCN, SiCN, etc.) (FIG. 5I).

In step S60, the initial capping structure, the protection layer, and portions of the preliminary top vias surrounded by the protection layer may be planarized, whereby a plurality of top vias are formed from the preliminary top vias, and a plurality of capping structures are formed on portions of the respective metal lines where the top vias are not formed. By the planarization in this step, top surfaces of the capping structures, the top vias, and the initial IMD structure become horizontally coplanar and aligned (FIG. 5J).

In step S70, the initial IMD structure may be removed, and a sidewall liner may be conformally layered on exposed top surfaces and side surfaces of the top vias, the metal lines, and the capping structures. The sidewall liner may be formed of a material such as a composite of silicon nitride (e.g., SiCN, SiBCN, etc.) to provide adhesion properties to the metal lines, the capping structures, and the top vias with respect to an IMD structure to be formed in a next step (FIG. 5K and 5L).

In step S80, an IMD structure may be formed to surround the top vias, the metal lines, and the capping structures with the sidewall liner thereon to isolate the metal lines and the top vias from each other (FIG. 5M).

In step S90, the IMD structure may be planarized based on the capping structures as well as the top vias to expose the top surfaces of the capping structures and the top vias (FIG. 5N). The planarization in this step may also remove portions of the sidewall liner layered on the top surface of the top vias and the capping structures.

In step S100, a plurality of upper-level metal lines may be formed on the exposed top surfaces of the top vias, the capping structures, and the IMD structure to complete an interconnect structure of a semiconductor device (FIG. 5N).

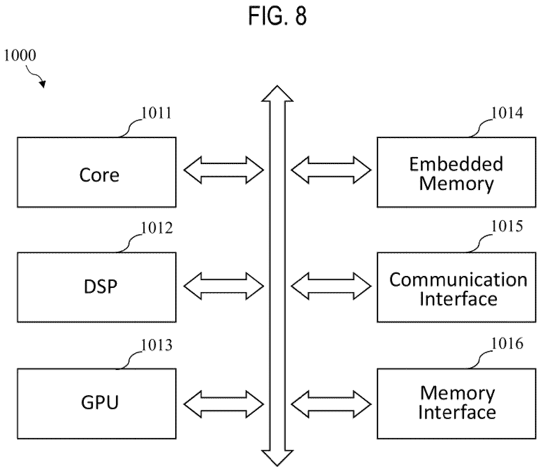

FIG. 8 is a block diagram of a system-on-chip (SoC) 1000 including a semiconductor device in which the interconnect structure 40 shown in FIGS. 4A-4C is formed, according to one or more embodiments.

Referring to FIG. 8, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus 1007.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data for use by the core 1011, the DSP 1012, and the GPU 1013. The communication interface 1015 may provide an interface for a communication network or one-to-one communication. The memory interface 1016 may provide an interface for an external memory of the SoC 1000, such as a dynamic random access memory (RAM) (DRAM), a flash memory, etc.

At least one of the core 211, the DSP 212, the GPU 213, and/or the embedded memory 214 may include a semiconductor device in which the interconnect structure 40 shown in FIGS. 4A-4C may be formed.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a base layer;
a 1^{st} metal line on the base layer;
a 1^{st} capping structure on the 1^{st} metal line; and
an isolation structure surrounding the 1^{st} metal line and the 1^{st} capping structure,
wherein the isolation structure and the 1^{st} capping structure comprise different dielectric materials.

2. The semiconductor device of claim 1, further comprising:
a 2^{nd} metal line at a same layer as the 1^{st} metal line; and
a top via formed on the 2^{nd} metal line,
wherein the top via is a protrusion structure of the 2^{nd} metal line.

3. The semiconductor device of claim 2, wherein the 1^{st} capping structure and the top via have a same height.

4. The semiconductor device of claim 2 or 3, wherein a bottom surface of the 1^{st} capping structure, a top surface of the 1^{st} metal line, and a top surface of the 2^{nd} metal line are horizontally coplanar or aligned.

5. The semiconductor device of any one of claims 2 to 4, further comprising a 3^{rd} metal line on a top surface of the top via and the 1^{st} capping structure.

6. The semiconductor device of any one of claims 2 to 5, wherein the 1^{st} capping structure and the top via have a same width in a direction in which the 1^{st} metal line and the 2^{nd} metal line are arranged.

7. The semiconductor device of any one of claims 2 to 6, wherein a portion of the isolation structure is formed between the 1^{st} metal line with the 1^{st} capping structure thereon and the 2^{nd} metal line with the top via thereon, and
wherein an air gap is formed in the portion of the isolation structure.

8. The semiconductor device of any one of claims 1 to 7, wherein the isolation structure comprises silicon oxide, and the 1^{st} capping structure comprises silicon nitride or a composite of silicon nitride.

9. The semiconductor device of claim 1 further comprising a top via formed on a portion of the 1^{st} metal line where the 1^{st} capping structure is not formed,
wherein the top via is a protrusion structure of the 1^{st} metal line.

10. The semiconductor device of claim 9, further comprising:
a 2^{nd} metal line at a same layer as the 1^{st} metal line; and
a 2^{nd} capping structure on the 2^{nd} metal line.

11. The semiconductor device of claim 10, wherein the 1^{st} metal line, the 1^{st} capping structure, the top via, the 2^{nd} metal line, and the 2^{nd} capping structure have a same width in a direction in which the 1^{st} metal line and the 2^{nd} metal line are arranged.

12. The semiconductor device of any one of claims 1 to 11, wherein the 1^{st} metal line is included in a back-end-of-line, BEOL, structure.

13. The semiconductor device of any one of claims 1 to 12, wherein the 1^{st} metal line comprises ruthenium, Ru.

14. A semiconductor device comprising:
a base layer;
a 1^{st} metal line on the base layer;
a 1^{st} capping structure on the 1^{st} metal line, the 1^{st} capping structure comprising a dielectric material; and
a 1^{st} top via on a portion of the 1^{st} metal line wherein the 1^{st} capping structure is not formed,
wherein the 1^{st} top via is a protrusion structure of the 1^{st} metal line, and
wherein the 1^{st} top via and the 1^{st} capping structure are at a same level and have a same height.

15. The semiconductor device of claim 14, further comprising:
a 2^{nd} metal line at a same layer as the 1^{st} metal line; and
a 2^{nd} top via on the 2^{nd} metal line,
wherein the 2^{nd} top via is a protrusion structure of the 2^{nd} metal line, and
wherein the 1^{st} capping structure is at a side of the 2^{nd} top via in a direction in which the 1^{st} metal line and the 2^{nd} metal line are arranged.
